# EUROPEAN PATENT SPECIFICATION

(11) **EP 0 749 161 B1**
(45) Date of publication and mention of the grant of the patent: **22.12.2004**
(21) Application number: 96109504.9
(22) Date of filing: 13.06.1996
(51) Int. Cl.: H01L 27/142

(54) **Integrated thin-film solar battery and method of manufacturing the same**
Integriertes Dünnschicht-Sonnenzellenmodul und Herstellungsverfahren
Pile solaire à couche mince intégrée et méthode de fabrication

(30) Priority: 15.06.1995 JP 14884795
(43) Date of publication of application: 18.12.1996
(73) Proprietor: Kanegafuchi Kagaku Kogyo Kabushiki Kaisha, Osaka-shi, Osaka 532 (JP)
(72) Inventor: Kurata, Shinichiro, Otsu-shi, Shiga 520-02 (JP); Hayashi, Katsuhiko, Otsu-shi, Shiga 520-01 (JP); Ishikawa, Atsuo, Otsu-shi, Shiga 520-02 (JP); Kondo, Masataka, Kobe-shi, Hyogo 651-11 (JP)
(74) Representative: VOSSIUS & PARTNER

(56) References cited:
- EP-A- 0 113 959
- DE-C- 3 714 920
- US-A- 4 542 578
- US-A- 4 755 475
- PATENT ABSTRACTS OF JAPAN vol. 004, no. 157 (E-032), 4 November 1980 & JP 55 108780 A (SHARP CORP), 21 August 1980,

## Description

The present invention relates to a method of manufacturing an integrated thin-film solar battery for forming a plurality of unit elements connected to each other on a substrate and an integrated thin-film solar battery manufactured by that method, and more particularly to an improvement in the electrical characteristic of the solar battery by improving the quality of an interface between a semiconductor layer and an electrode layer at an opposite side of the light receiving surface, thereby realizing an integrated thin-film solar battery with a high output.

The spread of solar batteries that convert energy of solar light directly into electrical energy has now started on a full scale, and a crystal based solar battery represented by single-crystal silicon, polycrystal silicon or the like has already been put to practical use as an outdoor power solar battery. On the other hand, attention has been drawn to a thin-film solar battery such as amorphous silicon as an inexpensive solar battery because less raw material is used therefor. However, in general, such a thin-film solar battery is still under development, and the extensive research and development efforts are made in order to allow the thin-film solar battery to be developed into a solar battery used outdoors on the basis of the actual results of using the thin-film solar battery as a power supply for such a device as a calculator which is already wide-spread.

The thin-film solar battery, as in a conventional thin-film device, is manufactured by a manufacturing process in which the deposition of a thin film using the CVD technique, the sputtering technique or the like and patterning of the thin film are repeated so as to obtain a desired structure. There is normally adopted an integrated structure in which a plurality of unit elements are connected in series or parallel on a single substrate. The power solar battery for use outdoors requires a large area that exceeds, for example, a substrate size 400 x 800 mm.

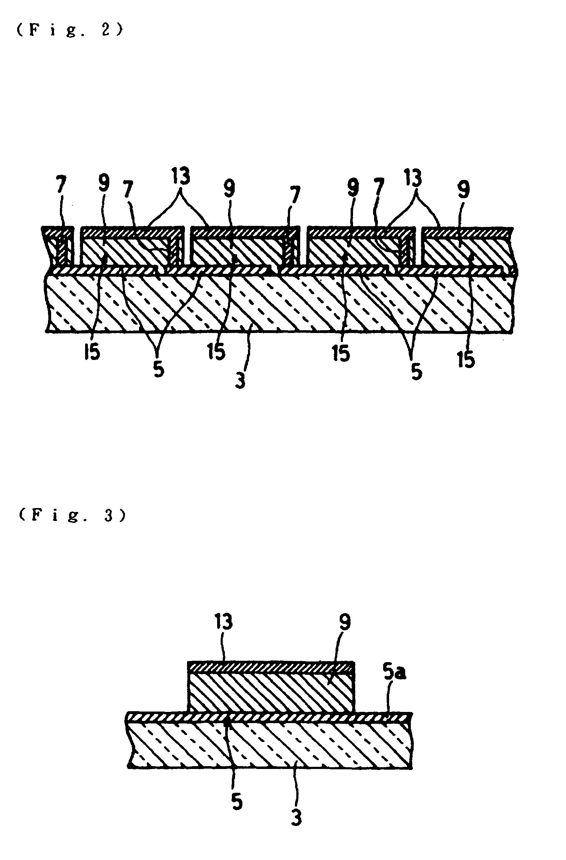

Fig. 2 is a cross-sectional view showing the structure of the above-mentioned conventional thin-film solar battery. This is the structure of an integrated thin-film solar battery which has been generally adopted until now, in which each unit element 15 has a first electrode layer 5, a semiconductor layer 9 made of amorphous silicon or the like, and a second electrode layer 13, which are stacked one on another in this order. The unit elements 15 adjacent to each other are connected in series through a connection opening 7 defined in the semiconductor layer 9. The first electrode layer 5 is usually formed of a transparent electrically conductive film such as tin oxide (SnO₂), zinc oxide (ZnO) or indium tin oxide (ITO), and the second electrode layer 13 is formed of a metal film such as aluminum (Al), silver (Ag) or chrome (Cr).

The above-mentioned conventional integrated thin-film solar battery is manufactured by a method which will be described hereinafter with reference to Fig. 2. On a glass substrate 3, the transparent electrically conductive film made of SnO₂, ZnO or ITO is deposited as the first electrode layer 5, and the first electrode layer 5 is divided into a plurality of sections in correspondence with power generation regions for integration by laser-scribing. Then, cleaning is conducted on the first electrode layer 5 in order to remove the remains melted and cut off by laser-scribing. The semiconductor layer 9 made of amorphous silicon with the structure of a p-i-n junction is deposited on the entire surface of the first electrode layer 5 through the plasma CVD technique. Subsequently, as in the first electrode layer 5, after the semiconductor layer 9 has been divided into a plurality of sections through the laser scribing technique, cleaning is conducted on the semiconductor layer 9 in order to remove the remains melted and cut off by laser-scribing. Further, as the second electrode layer 13, a metal film made of Al, Ag, Cr or the like is deposited on the semiconductor layer 9 in a single layer or a plurality of layers, and divided into a plurality of sections through the laser scribing technique as in the first electrode layer 5, thus completing an integrated thin-film solar battery having a large area.

However, in the above-mentioned conventional integrated thin-film solar battery, there is found such a phenomenon that a curve factor (FF value) of its output characteristics is low. Generally, in the manufacture of the integrated thin-film solar battery, it is needless to say that the individual process conditions such as the thickness of the respective electrode layers 5 and 13 or the quality of the semiconductor layer 9 are optimized in order to improve the characteristics. Since the large area of the substrate 3 makes an experiment for optimizing the individual process conditions complicated, a thin-film solar battery having a small area is normally manufactured through a simple process as an advance experiment, for evaluating the characteristics. Then, the optimum conditions of the individual processes obtained in this manner are fed back to the process of manufacturing the thin-film solar battery having a large area.

However, although excellent numerical values are obtained by the advance experiment, when its optimum conditions are fed back to the process of manufacturing the thin-film solar battery having a large area, a similarly excellent result cannot be obtained as the numerical values obtained by the advance experiment, and most of the results have a lowered in value. Hence, an improvement in the above-mentioned FF value is indispensable and urgently required for the integrated thin-film solar battery having a large area, in order to improve the conversion efficiency.

Under the existing circumstances, the present inventors have studied the cause of lowering the FF value in detail with the result that they have proved that the interface between the semiconductor layer 9 and the second electrode layer 13 causes the FF value to be lowered.

Fig. 3 shows a cross-sectional structure of a thin-film solar battery having a small area, used in the above-mentioned advance experiment. The thin-film solar battery having a small area is obtained in such a manner that a first electrode layer 5 made of SnO₂, ZnO, ITO or the like, a semiconductor layer 9 made of an amorphous silicon or the like, and a second electrode layer 13 made of Al, Ag, Cr or the like are stacked on a substrate 3 in this order, and patterning is finally conducted on the periphery of the second electrode layer 13 and the semiconductor layer 9. The characteristics of that solar battery are measured by putting a measuring probe to an exposed portion 5a of the first electrode layer 5 and the second electrode layer 13. The thin-film solar battery having a small area is not subjected to a cleaning processing since the semiconductor layer 9 is deposited on the substrate 3 until the second electrode layer 13 is deposited thereon, because the first electrode layer 5, the semiconductor layer 9 and the second electrode layer 13 are continuously formed. In other words, it has been proved that an interface between the semiconductor layer 9 and the second electrode layer 13 absorbs moisture and so on, and the generation of a natural oxide film on the amorphous silicon surface is facilitated with the result that the FF value is lowered. However, in case of the integrated thin-film solar battery having a large area, because the laser scribing technique is applied for patterning, the remains melted and cut off by laser-scribing unavoidably occur. Unless the remains are removed, the adhesion of the second electrode layer 13 and the first electrode layer 5 in a connecting opening 7 is degraded. This adversely affects the characteristics and reliability of the solar battery more than the lowering of the FF value. Hence, the cleaning processing for removing the remains melted and cut off by laser-scribing is essential in the process of manufacturing the integrated thin-film solar battery having a large area.

The above-mentioned conventional method makes it impossible to improve the FF value while conducting the cleaning processing.

Further solar batteries are disclosed in US 542 578, US 4 755 475,DE 3 714 920, JP 55108780 and EP113959.

The present invention has been made in view of the above circumstances, and therefore an object of the present invention is to provide an integrated thin-film solar battery as claimed in claim 1 having a structure which is capable of improving the FF value while conducting the cleaning processing, and a method of manufacturing the same as claimed in claim 8.

In order to solve the above problems, the present invention has been achieved by the provision of an integrated thin-film solar battery having a plurality of unit elements connected in series, in which a plurality of semiconductor layers are disposed on a plurality of first electrode layers which are divided into a plurality of regions on a substrate in such a manner that each of the semiconductor layers is formed on two adjacent first electrodes and has a connection opening on one of the two first electrodes, an electrically conductive layer is formed in a region except for the connection opening on each of the semiconductor layers, a second electrode layer is disposed on each of the electrically conductive layers in a state where the second electrode layer is electrically connected to one of the two electrode layers through the connection opening, to thereby form a region interposed between the second electrode layer and the other first electrode layer as the unit element.

The electrically conductive layer is made of a transparent electrically conductive film material consisting of a transparent metal oxide material, and the transparent electrically conductive film material may mainly contain tin oxide, zinc oxide or indium tin oxide therein.

Also, the above-mentioned integrated thin-film solar battery can be manufactured by a method of manufacturing the integrated thin-film solar battery in which, after a plurality of first electrode layers corresponding to a plurality of power generation regions have been formed on a substrate, a plurality of semiconductor layers each having a connection opening that permits a part of each first electrode layer to be exposed and a plurality of electrically conductive layers are formed on the first electrode layers over the plurality of power generation regions, and subsequently after a second electrode layer has been formed on the electrically conductive layers, the second electrode layer is divided into a plurality of sections corresponding to the plurality of power generation regions by removing at least the second electrode layer and the electrically conductive layer in the vicinity of each of the connection openings, to thereby form a plurality of unit elements connected in series, each being formed of a region interposed between each first electrode layer and the second electrode layer, on the substrate.

The above-mentioned integrated thin-film solar battery is so designed that the first electrode layer is divided into a plurality of regions on the substrate through the conventional method, the semiconductor layer is formed into a plurality of regions in such a manner that each of the semiconductor layers is formed on two adjacent first electrodes and has a connection opening on one of the two first electrodes, the electrically conductive layer is formed in a region except for the connection opening on each of the semiconductor layers, and the second electrode layers is disposed on each of the electrically conductive layer in a state where the second electrode layer is electrically connected to one of the two electrode layers through the connection opening. With such a structure, there are formed the plurality of unit elements connected in series, each being formed by a region interposed between the second electrode layer and the other first electrode layer.

The thin-film solar battery of the present invention has a structure in which the connection opening can be defined through the laser scribing technique after the semiconductor layer and the electrically conductive layer are sequentially deposited since the electrically conductive layer is formed in a region except for the connection opening on the semiconductor layer as described above. That is, the thin-film solar battery of the invention has a structure with which it can be manufactured without the semiconductor layer being in direct contact with water used for cleaning or external air. Hence, in the integrated thin-film solar battery of the present invention, a natural oxide film derived from the cleaning process is not generated on the surface of the semiconductor layer.

In this example, the electrically conductive layer is made of a transparent electrically conductive film material consisting of a transperant method oxide layer such as SnO₂, ZnO or ITO, no natural oxide film is produced on its surface by the cleaning process, and the interface between the electrically conductive layer and the second electrode layer is also kept in an excellent state. Furthermore, alloying does not occur between the electrically conductive layer and the semiconductor layer. Hence, any factors that lead to the degradation of the FF value can be more completely removed.

The method of manufacturing the integrated thin-film solar battery thus structured is as follows.

First, the first electrode layer is formed on the substrate so as to correspond to a plurality of power generation regions. The transparent electrically conductive film made of SnO₂, ZnO, ITO or the like is deposited on the substrate, and for integration, the first electrode layer is then melted and cut off in correspondence with the plurality of power generation regions through the laser scribing technique. Subsequently, a cleaning process such as water-washing is conducted on the first electrode layer in order to remove the remains melted and cut off by laser-scribing. Although moisture is attracted onto the surface of the first electrode layer through the cleaning process, no natural oxide film is produced thereon because the first electrode layer is a metal oxide.

Subsequently, a plurality of semiconductor layers each having a connection opening that permits a part of each first electrode layer to be exposed and a plurality of electrically conductive layers are formed on the first electrode layers over the plurality of power generation regions through the plasma CVD technique. The semiconductor layer is formed of an amorphous silicon layer having, for example, a p-i-n junction structure, and the electrically conductive layer may be made of SnO₂, ZnO, ITO or the like. In the formation of the connection opening, after both the semiconductor layer and the electrically conductive layer have been deposited, they are melted and cut off through the laser scribing technique, to thereby form the connecting opening into a groove shape.

Similarly, a cleaning process such as water-washing is conducted in order to remove the remains melted and cut off by laser-scribing. In this situation, the semiconductor layer is not in direct contact with water because its surface is covered with the electrically conductive layer, with the result that no natural oxide film derived from the cleaning process is generated on the surface of the semiconductor layer. Although moisture is attracted onto the surface of the first electrode layer, no natural oxide film is produced thereon as the electrically conductive layer is made of a metal oxide such as SnO₂, ZnO or ITO. Hence, the electrically conductive layer functions as a protective layer for the semiconductor layer.

Subsequently after the second electrode layer made of Al, Ag, Cr or the like has been formed on the electrically conductive layers, the second electrode layer is divided in correspondence to the plurality of power generation regions by removing at least the second electrode layer and the electrically conductive layer in the vicinity of each of the connection openings, to thereby form a plurality of unit elements connected in series, each being formed of a region interposed between each first electrode layer and the second electrode layer, on the substrate. Similarly, the second electrode layer and the electrically conductive layer are removed through the laser scribing technique, and a cleaning process such water-washing is conducted in order to remove the remains melted and cut off by laser-scribing.

As described above, in the manufacturing method of the present invention, since the semiconductor layer is not in direct contact with cleaning water or external air, the interface between the semiconductor layer and the second electrode layer is improved in quality, thereby contributing to an improvement in the FF value of the solar battery.

The above and other objects and features of the present invention will be more apparent from the following description taken in conjunction with the accompanying drawings.
Fig. 1 is a cross-sectional diagram explanatorily showing the structure of an integrated thin-film solar battery in accordance with the present invention;
Fig. 2 is a cross-sectional diagram explanatorily showing the structure of a conventional integrated thin-film solar battery; and
Fig. 3 is a cross-sectional diagram explanatorily showing a thin-film solar battery having a small area, used for studying the process conditions for manufacturing the integrated thin-film solar battery.

Hereinafter, a description will be given in more detail of specific embodiments of the present invention with reference to the accompanying drawings.

### (First Embodiment)

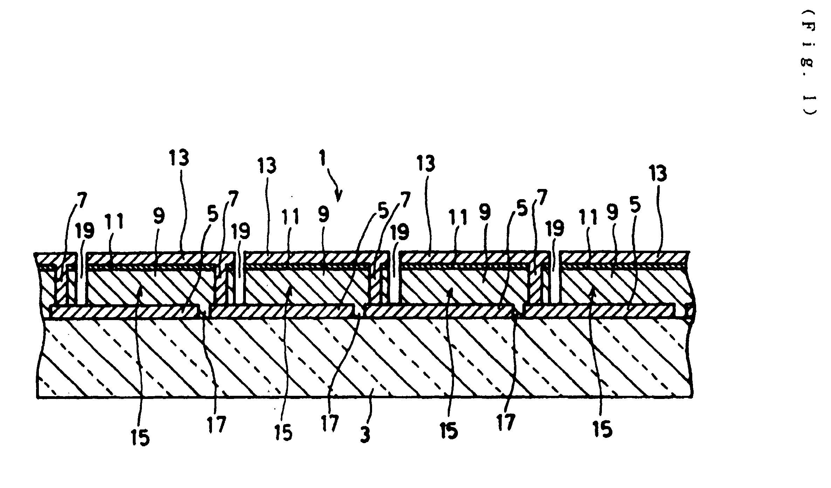

Fig. 1 shows an example of a cross-sectional structure of an integrated thin-film solar battery 1 in accordance with the present invention. In the example, there is shown an integrated thin-film solar battery 1 having a plurality of unit elements 15 connected in series. In the integrated thin-film solar battery 1, a plurality of semiconductor layers 9 are disposed on a plurality of first electrode layers 5 which are divided into a plurality of regions on a substrate 3 in such a manner that each of the semiconductor layers 9 is formed on two adjacent first electrodes 5 and has a connection opening 7 on one of the two first electrodes 5. An electrically conductive layer 11 is formed in a region except for the connection opening 7 on each of the semiconductor layers 9. A second electrode layer 13 is disposed on each of the electrically conductive layers 11 in a state where the second electrode layer 13 is electrically connected to one of the two electrode layers 5 through the connection opening 7, thereby forming, as the unit element 15, a region interposed between the second electrode layer 13 and the other first electrode layer 5.

Hereinafter, a description will be given in more detail of a method of manufacturing the above-mentioned integrated thin-film solar battery with reference to Fig. 1.

A transparent electrically conductive film made of SnO₂, ZnO, ITO or the like is deposited on the glass substrate 3 as the first electrode layer 5, and for integration, the first electrode layer 5 is then melted and cut off in correspondence with a plurality of power generation regions through the laser scribing technique, to thereby form a plurality of separation grooves 17. In case of an integrated thin-film solar battery having a large area, for example, a plurality of strip-shaped power generation regions are formed along one direction of the substrate 3. In case of the integrated thin-film solar battery having a large area, as one example, a glass substrate of 910 x 455 x 4 mm³ is used, and the surface resistance of the first electrode layer 5 is set to the order of 10 ohms. Subsequently, cleaning is conducted on the first electrode layer 5 in order to remove the remains melted and cut off by laser-scribing. An amorphous silicon hydride layer having a p-i-n structure is deposited on the entire surface of the first electrode layers 5 formed in correspondence with the plural power generation regions as a semiconductor layer 9 through the plasma CVD technique. The amorphous silicon hydride layer is produced in the manner stated bellow.

First, the substrate 3 is introduced into a high vacuum chamber of 10⁻⁵ Torr (1 Torr = 133.3 Pa) or less, and silane (SiH₄), diborane (B₂H₆) and methane (CH₄) are then introduced into the chamber as film formation gases of a substrate temperature of 140 to 200 °C. The reaction pressure is set to approximately 1.0 Torr, and p-type amorphous silicon hydride carbide is deposited to a thickness of 50 to 200 Å (10 Å = 1 nm) through RF discharge. Thereafter, only silane gas is introduced into the chamber as the film formation gas, the reaction pressure is set to 0.2 to 0.7 Torr, and i-type amorphous silicon hydride is deposited to a thickness of approximately 3000 Å through RF discharge. Furthermore, silane, phosphine (PH₃) and hydrogen (H₂) are introduced into the chamber as film formation gases, the reaction pressure is set to approximately 1.0 Torr, and n-type microcrystal silicon is deposited to a thickness of approximately 100 to 200 Å through RF discharge.

The deposition conditions of the semiconductor layer 9 described above are shown merely as one example. For example, the first electrode layers 5 may be also have a n-i-p structure, or a tandem structure. The primary material of the semiconductor layer 9 may be not only amorphous silicon hydride but also amorphous silicon, multi-crystal or microcrystal, or a combination thereof. Also, silicon may be replaced by silicon carbide, silicon germanium, germanium, a III-V group compound, II-VI group compound, I-III-VI group compound, or the like. Furthermore, it may be replaced by a combination of those compounds.

An electrically conductive layer 11 is deposited on the semiconductor layers 9 sequentially without conducting a cleaning process through the sputtering technique. Specifically, the substrate 3 on which the semiconductor layers 9 are deposited is introduced into a sputter chamber from which a gas is then exhausted to a high vacuum of 1 x 10⁻⁶ Torr or higher. Argon gas (Ar) is introduced into the sputter chamber as a sputter gas, and ZnO doped with aluminum oxide (Al₂O₃) is then deposited to a thickness of 800 to 1000 Å under a pressure of 1 to 5 mTorr through RF discharge. The material of the electrically conductive layer 11 is a transparent electrically conductive material consisting of a metal oxide material such as SnO₂ or ITO. Furthermore, that material may be a laminate of those materials. What is important is that the electrically conductive layer 11 is deposited on the semiconductor layers 9 sequentially without conducting a cleaning process. More preferably, the electrically conductive layer 11 may be deposited sequentially, for example, within a device where a CVD chamber is coupled to the sputter chamber, without exposing the conductive layer 11 to the atmosphere after the deposition of the semiconductor layer 9.

Subsequently, the semiconductor layer 9 and the electrically conductive layer 11 are melted and cut off simultaneously through the laser scribing technique, to thereby define a plurality of connection openings 7 adjacent to the separation grooves 17 of the first electrode layers 5, which have been already formed. Then, after cleaning is conducted on the connection openings 7 in order to remove the remains melted and cut off by the laser scribing, a metal such as Al, Ag, Cr or the like is deposited on the electrically conductive layers 11 as a second electrode layer 13 through the sputtering technique or the vacuum vapor deposition technique as in the above manner. Thereafter, at least the second electrode layer 13, the electrically conductive layer 11 and the n-type microcrystal silicon layer in the vicinity of each of the connection openings 7 at an opposite side of the separation groove 17 of the first electrode layer 5 with respect to each of the connection openings 7 are removed through the laser scribing technique to thereby form an upper separation groove 19 so that the second electrode layer 13 is divided into a plurality of power generation regions. With this arrangement, a plurality of unit elements 15 each consisting of a region which is interposed between the first electrode layer 5 and the second electrode layer 13 are connected in series and formed on the substrate 3.

Finally, cleaning is conducted on the unit elements 15 in order to remove the remains melted and cut off by laser-scribing, and as occasion demands, an appropriate passivation layer made of epoxy resin or the like is coated on the final product.

### (Second Embodiment)

The processes until the deposition of the semiconductor layer 9 are conducted in the same procedure as the above-mentioned first embodiment. Subsequently, an electrically conductive layer 11 is deposited on the semiconductor layer 9 sequentially without conducting a cleaning process through the sputtering technique. Specifically, the substrate 3 on which the semiconductor layers 9 are deposited is introduced into a sputter chamber from which a gas is then exhausted to a high vacuum of 1 x 10⁻⁶ Torr or higher. Argon gas (Ar) is introduced into the sputter chamber as a sputter gas, and ZnO doped with aluminum oxide (Al₂O₃) is then deposited to a thickness of approximately 500 Å under a pressure of 1 to 5 mtorr through RF discharge. The material of the electrically conductive layer 11 may be a transparent electrically conductive material such as SnO₂ or ITO, or a laminate of those materials instead of ZnO. As above, what is important is that the electrically conductive layer 11 is deposited on the semiconductor layers 9 sequentially without conducting a cleaning process. More preferably, the electrically conductive layer 11 may be deposited sequentially, for example, within a device where a CVD chamber is coupled to the sputter chamber, without exposing the conductive layer 11 to the atmosphere after the deposition of the semiconductor layer 9.

Subsequently, the semiconductor layer 9 and the electrically conductive layer 11 are melted and cut off simultaneously through the laser scribing technique, to thereby define a plurality of connection openings 7 adjacent to the separation grooves 17 of the first electrode layers 5, which have been already formed. Then, after cleaning is conducted on the connection openings 7 in order to remove the remains melted and cut off by the laser scribing, a multi-layer film consisting of a transparent electrically conductive layer made of ZnO, SnO₂, ITO or the like and a metal layer made of Al, Ag, Cr or the like is deposited on the electrically conductive layers 11 as a second electrode layer 13 through the sputtering technique or the vacuum vapor deposition technique as in the above manner. Specifically, the substrate 3 on which the electrically conductive layers 11 are deposited is introduced into a sputter chamber from which a gas is then exhausted to a high vacuum of 1 x 10⁻⁵ Torr or higher. Ar gas is introduced into the sputter chamber as a sputter gas, and ZnO doped with Al₂O₃ is then deposited to a thickness of approximately 500 Å under a pressure of 1 to 5 mtorr through RF discharge. Subsequently, the substrate 3 is introduced into a sputter chamber from which a gas is then exhausted to a high vacuum of 1 x 10⁻⁵ Torr or higher. Ar gas is introduced into the sputter chamber as a sputter gas, and Ag is deposited to a thickness of approximately 3000 A as the metal layer through RF discharge under a pressure of 1 x 10⁻⁵ Torr or higher. It is desirable to deposit ZnO and Ag sequentially without breaking the vacuum. However, if the vacuum is broken in the chamber once, then the layer may be deposited in another chamber or device. Also, the metal layer may be of a multi-layer structure such as a laminate of, for example, Ag and Al, and the thickness may be set to at least 1000 Å or more, although this depends on the kind of material. Furthermore, the RF sputtering may be replaced by DC sputtering.

Thereafter, at least the second electrode layer 13, the electrically conductive layer 11 and the n-type microcrystal silicon layer in the vicinity of each of the connection openings 7 at an opposite side of the separation groove 17 of the first electrode layer 5 with respect to each of the connection openings 7 are removed through the laser scribing technique to thereby form an upper separation groove 19 so that the second electrode layer 13 is divided into a plurality of power generation regions. With this arrangement, a plurality of unit elements 15 each consisting of a region which is interposed between the first electrode layer 5 and the second electrode layer 13 are connected in series and formed on the substrate 3. Finally, cleaning is conducted on the unit elements 15 in order to remove the remains melted and cut off by laser-scribing, and as occasion demands, an appropriate passivation layer made of epoxy resin or the like is coated on the final product.

What is important to this embodiment is that the thickness of ZnO deposited on the semiconductor layer 9 is set to a range of 600 to 1200 Å, preferably, 800 to 1000 Å. This is because light incident from the side of the glass substrate 3 is effectively reflected at the side of the second electrode layer 13 to obtain "a light shut-up effect". Hence, in the first embodiment where the second electrode layer 13 is made of only metal, ZnO as the electrically conductive layer 11 is deposited to a thickness of 800 to 1000 Å. In the second embodiment where the second electrode layer 13 is of a double-layer structure consisting of the transparent electrically conductive layer and the metal layer, ZnO as the electrically conductive layer 11 and Ag as the second electrode layer 13 are deposited in a thickness of 500 Å each to provide a thickness of 1000 Å in total.

The above-mentioned product of the present invention and the conventional product which has been subjected to a cleaning process in a state where the surface of the semiconductor layer is exposed were compared with each other in the FF value and conversion efficiency under artificial solar light of AM 1.5. As a result, the conventional product was 0.61 to 0.68 in FF value and 7.3 to 9.0 % in conversion efficiency, whereas the product according to the present invention was 0.68 to 0.71 in FF value and 8.8 to 10.4 % in conversion efficiency. Thus, it has been confirmed that the FF value and the conversion efficiency are remarkably improved.

Furthermore, the present invention can obtain the following secondary effects. In general, Ag has a high reflection factor but not such an excellent adhesion to the underlayer. In the case where Ag is used as the second electrode layer 13 of the solar battery as in the present invention, there is a case where Ag contributes to an improvement of the conversion efficiency but the adhesive strength between Ag and the first electrode is weakened. However, the structure of the present invention is very useful in order to prevent the above problem. In other words, the unevenness of the surface of the electrically conductive layer 11 formed on the semiconductor layer 9 is increased, which can improve the adhesive strength between the electrically conductive layer 11 and the second electrode layer 13 deposited on the conductive layer 11. Then, in the structure in accordance with the present invention, because the semiconductor layer 9 exists on both sides of each connection opening 7, even though the adhesive strength between the first electrode layer 5 and the second electrode layer 13 in the connection opening 7 is weakened, the electrically conductive layer 11 adheres to the second electrode layer 13 with a high adhesive strength on both sides of the connection opening 7, which can prevent the separation between the first electrode layer 5 and the second electrode layer 13 in the connection opening 7. In this example, one idea could be to roughen the surface of the first electrode layer 5. However, when the unevenness of the surface of the first electrode layer 5 is increased, because the thickness of the semiconductor layer 9 is 3000 to 4000 Å, there is a high risk of increasing a leak current flowing between the first electrode layer 5 and the second electrode layer 13. Hence, such an idea is undesirable. Also, that the unevenness of the surface of the electrically conductive layer 11 is increased can contribute to irregular reflection of incident light at the second electrode layer 13 side, and is very useful in the above-mentioned "light shut-up effect".

Furthermore, the structure in which the second electrode layer 13 of the present invention is of the double-layer structure consisting of the transparent electrically conductive film and the metal layer is disclosed in Japanese Patent Examined Publication No. Sho 60-41878. However, a primary object of the structure disclosed in that publication is completely different from that of the present invention. Also, such a structure does not contribute to an improvement in the adhesive strength between the above first electrode layer 5 and the second electrode layer 13 even from its structural viewpoint.

As was described above, the present invention provides excellent advantages stated below.

The thin-film solar battery of the present invention has a structure in which the connection opening can be defined through the laser scribing technique after the semiconductor layer and the electrically conductive layer are sequentially deposited since the electrically conductive layer is formed in a region except for the connection opening on the semiconductor layer as described above. That is, the thin-film solar battery of the invention has a structure allowing it to be manufactured without the semiconductor layer being in direct contact with water used for cleaning or external air, which is different from the conventional thin-film solar battery. Hence, in the integrated thin-film solar battery of the present invention, because a natural oxide film derived from the cleaning process is not generated on the surface of the semiconductor layer, the FF value is remarkably improved in comparison with the conventional integrated thin-film solar battery, which can realize a remarkable improvement of the convention efficiency.

When the electrically conductive layer is made of a transparent electrically conductive film material such as SnO₂, ZnO or ITO, no natural oxide film is produced on its surface by the cleaning process, and the interface between the electrically conductive layer and the second electrode layer is also kept in an excellent state. Furthermore, because alloying does not occur between the electrically conductive layer and the semiconductor layer, any factors that lead to the degradation of the FF value can be more completely removed, thereby being capable of more surely achieving an improvement in the conversion efficiency.

Also, according to the present invention, because the semiconductor layer exists on both sides of each connection opening where the first electrode layer adheres to the second electrode layer, the unevenness of the surface of the electrically conductive layer is increased, and the adhesive strength between the electrically conductive layer and the second electrode layer deposited thereon is improved, even though the adhesive strength between the first electrode layer and the second electrode layer in the connection opening is weakened, the electrically conductive layer adheres to the second electrode layer with a high adhesive strength on both sides of the connection opening, thereby being capable of preventing the separation between the first electrode layer and the second electrode layer in the connection opening. Hence, the thin-film solar battery in accordance with the present invention is excellent from the viewpoint of reliability.

Furthermore, when the transparent electrically conductive material is used for the electrically conductive layer, light incident from the substrate side is effectively reflected on the second electrode layer side, thereby being capable of obtaining the "light shut-up effect" and contributing to an improvement in output current.

The foregoing description of preferred embodiments of the invention has been presented for purposes of illustration and description. It is not intended to be exhaustive or to limit the invention to the precise forms disclosed, and modifications and variations are possible in light of the above teachings or may be acquired from practice of the invention. The embodiments were chosen and described in order to explain the principles of the invention and its practical application to enable one skilled in the art to utilize the invention in various embodiments and with various modifications as are suited to the particular use contemplated. It is intended that the scope of the invention be defined by the claims appended hereto.

## Claims

1. An integrated thin-film solar battery (1) having a plurality of unit elements (15) connected in series, comprising:
a substrate (3);
a plurality of first electrode layers (5) of transparent conductive oxide divided into a plurality of regions and formed on the substrate (3);
a plurality of laminates each including a semiconductor layer (9) and a first electrically conductive layer (11) laminated on the semiconductor layer (9) disposed on said plurality of first electrode layers (5) in such a manner that each of the laminates is formed on two adjacent first electrodes (5) and has a connection opening (7) on one of the two first electrodes (5) said first electrically conductive layer being not formed in said connection opening; and
second electrode layers (13) of metallic material disposed on each of the laminates in a state where the second electrode layers (13) are electrically connected to one of the two first electrode layers (5) through the connection opening (7) to form a region interposed between the second electrode layer (13) and the other first electrode layer as the unit element (15);
**characterized in that**
said first electrically conductive layer (11) consists of a transparent metal oxide material.

2. The integrated thin-film solar battery as claimed in claim 1, wherein said first electrically conductive layer (11) has a thickness in a range of 600 Å to 1200 Å (10 Å = 1 nm).

3. The integrated thin-film solar battery as claimed in claim 1 or 2, further comprising a second electrically conductive layer of transparent metal oxide between the first transparent electrically conductive layer (11) and said second electrode layer (13).

4. The integrated thin-film solar battery as claimed in claim 1, 2 or 3, wherein the second electrode layer (13) consists of silver.

5. The integrated thin-film solar battery as claimed in any of claims 1 to 4, wherein the transparent metal oxide material of the first and second transparent electrically conductive layers (11) consists of zinc oxide, tin oxide or indium tin oxide.

6. The integrated thin-film solar battery as claimed in any of claims 1 to 5, wherein the semiconductor layers (9) are doped with hydrogen.

7. The integrated thin-film solar battery as claimed in any of claims 3 to 6, wherein the total thickness of said first and second transparent metal oxide layers is set to 1000 Å.

8. A method of manufacturing an integrated thin-film solar battery (1) having a plurality of unit elements (15) connected in series, comprising the steps in the given order of:
forming on a substrate (3) a plurality of first electrode layers (5) of transparent conductive oxide, wherein each of said layers (5) is the first layer of the plurality of unit elements (15);
forming a laminate including a semiconductor layer (9) and a first electrically conductive layer (11) laminated on the semiconductor layer (9) covering said plurality of first electrode layers (5);
forming connection openings (7). each of which penetrates the laminate and exposes a part of each first electrode layer (5);
forming a second electrode layer (13) of metallic material on the laminate in a state where the second electrode layer (13) is electrically connected to each first electrode layer (5) through said connection opening (7); and
forming isolation grooves (19) for dividing the second electrode layer (13) into a plurality of second electrode regions (13) in a state where the second electrode regions (13) are electrically connected to one of two adjacent first electrode layers (5) through the connection opening (7) to form a region interposed between the second electrode region (13) and the other first electrode layer as the unit element (15);
**characterized in that**
said first electrically conductive layer (11) is made of a transparent metal oxide material.

9. The method as claimed in claim 8, wherein the thickness of the first transparent electrically conductive layers (11) is set in a range of 600 Å to 1200 Å.

10. The method as claimed in claim 8 or 9, wherein the semiconductor layers (9) are doped with hydrogen.

11. The method as claimed in claims 8, 9 or 10, wherein the transparent electrically conductive layers (11) are formed without being exposed to water or external air after forming said semiconductor layers (9).

12. A method as claimed in any of claims 8 to 11, further comprising the step of:
forming a second electrically conductive layer of transparent metal oxide between the first transparent electrically conductive layer (11) and said second electrode layer (13).

13. The method as claimed in any of claims 8 to 12, wherein the transparent metal oxide materials of the first and second transparent electrically conductive layers are made of zinc oxide, tin oxide or indium tin oxide.

14. The method as claimed in any of claims 8 to 13, wherein said second electrode layers (13) are made of silver.

15. The method as claimed in claim 14, wherein the second electrode layers (13) are formed by depositing said metal layer of silver in a vacuum state after depositing said first and/or second transparent metal oxide layers of zinc oxide, tin oxide or indium tin oxide.

16. The method as claimed in any of claims 12 to 15, wherein the total thickness of said first and second transparent metal oxide layers is set to 1000 Å.

## Patentansprüche

1. Integrierte Dünnfilm-Solarbatterie (1), die mehrere in Reihe verbundene Elementeinheiten (15) hat, mit:
einem Substrat (3);
mehreren ersten Elektrodenschichten (5) aus transparentem leitendem Oxid, die in mehrere Bereiche aufgeteilt und auf dem Substrat (3) gebildet sind;
mehreren Laminaten mit jeweils einer Halbleiterschicht (9) und einer auf die Halbleiterschicht (9) laminierten ersten elektrisch leitenden Schicht (11), die auf den ersten Elektrodenschichten (5) so angeordnet sind, daß jedes der Laminate auf zwei benachbarten ersten Elektroden (5) gebildet ist und eine Verbindungsöffnung (7) auf einer der beiden ersten Elektroden (5) hat, wobei die erste elektrisch leitende Schicht nicht in der Verbindungsöffnung gebildet ist; und
zweiten Elektrodenschichten (13) aus metallischem Material, die auf jedem der Laminate in einem Zustand angeordnet sind, in dem die zweiten Elektrodenschichten (13) mit einer der beiden ersten Elektrodenschichten (5) durch die Verbindungsöffnung (7) elektrisch verbunden sind, um einen zwischen der zweiten Elektrodenschicht (13) und der anderen ersten Elektrodenschicht eingefügten Bereich als Elementeinheit (15) zu bilden;
**dadurch gekennzeichnet, daß**
die erste elektrisch leitende Schicht (11) aus einem transparenten Metalloxidmaterial besteht.

2. Integrierte Dünnfilm-Solarbatterie nach Anspruch 1, wobei die erste elektrisch leitende Schicht (11) eine Dicke in einem Bereich von 600 Å bis 1200 Å (10 Å = 1 nm) hat.

3. Integrierte Dünnfilm-Solarbatterie nach Anspruch 1 oder 2, ferner mit einer zweiten elektrisch leitenden Schicht aus transparentem Metalloxid zwischen der ersten transparenten elektrisch leitenden Schicht (11) und der zweiten Elektrodenschicht (13).

4. Integrierte Dünnfilm-Solarbatterie nach Anspruch 1, 2 oder 3, wobei die zweite Elektrodenschicht (13) aus Silber besteht.

5. Integrierte Dünnfilm-Solarbatterie nach einem der Ansprüche 1 bis 4, wobei das transparente Metalloxidmaterial der ersten und zweiten transparenten elektrisch leitenden Schicht (11) aus Zinkoxid, Zinnoxid oder Indium-Zinn-Oxid besteht.

6. Integrierte Dünnfilm-Solarbatterie nach einem der Ansprüche 1 bis 5, wobei die Halbleiterschichten (9) mit Wasserstoff dotiert sind.

7. Integrierte Dünnfilm-Solarbatterie nach einem der Ansprüche 3 bis 6, wobei die Gesamtdicke der ersten und zweiten transparenten Metalloxidschicht auf 1000 Å eingestellt ist.

8. Verfahren zur Herstellung einer integrierten Dünnfilm-Solarbatterie (1), die mehrere in Reihe verbundene Elementeinheiten (15) hat, mit den folgenden Schritten in der genannten Reihenfolge:
Bilden mehrerer erster Elektrodenschichten (5) aus transparentem leitendem Oxid auf einem Substrat (3), wobei jede der Schichten (5) die erste Schicht der mehreren Elementeinheiten (15) ist;
Bilden eines Laminats mit einer Halbleiterschicht (9) und einer auf die Halbleiterschicht (9) laminierten ersten elektrisch leitenden Schicht (11), das die mehreren ersten Elektrodenschichten (5) bedeckt;
Bilden von Verbindungsöffnungen (7), von denen jede das Laminat durchdringt und einen Teil jeder ersten Elektrodenschicht (5) freilegt;
Bilden einer zweiten Elektrodenschicht (13) aus metallischem Material auf dem Laminat in einem Zustand, in dem die zweite Elektrodenschicht (13) mit jeder ersten Elektrodenschicht (5) durch die Verbindungsöffnung (7) elektrisch verbunden ist; und
Bilden von Isoliernuten (19) zum Aufteilen der zweiten Elektrodenschicht (13) in mehrere zweite Elektrodenbereiche (13) in einem Zustand, in dem die zweiten Elektrodenbereiche (13) mit einer von zwei benachbarten ersten Elektrodenschichten (5) durch die Verbindungsöffnung (7) elektrisch verbunden sind, um einen zwischen dem zweiten Elektrodenbereich (13) und der anderen ersten Elektrodenschicht eingefügten Bereich als Elementeinheit (15) zu bilden;
**dadurch gekennzeichnet, daß**
die erste elektrisch leitende Schicht (11) aus einem transparenten Metalloxidmaterial hergestellt ist.

9. Verfahren nach Anspruch 8, wobei die Dicke der ersten transparenten elektrisch leitenden Schichten (11) in einem Bereich von 600 Å bis 1200 Å eingestellt wird.

10. Verfahren nach Anspruch 8 oder 9, wobei die Halbleiterschichten (9) mit Wasserstoff dotiert sind.

11. Verfahren nach Anspruch 8, 9 oder 10, wobei die transparenten elektrisch leitenden Schichten (11) gebildet werden, ohne Wasser oder Außenluft nach Bildung der Halbleiterschichten (9) ausgesetzt zu sein.

12. Verfahren nach einem der Ansprüche 8 bis 11, ferner mit dem folgenden Schritt:
Bilden einer zweiten elektrisch leitenden Schicht aus transparentem Metalloxid zwischen der ersten transparenten elektrisch leitenden Schicht (11) und der zweiten Elektrodenschicht (13).

13. Verfahren nach einem der Ansprüche 8 bis 12, wobei die transparenten Metalloxidmaterialien der ersten und zweiten transparenten elektrisch leitenden Schicht aus Zinkoxid, Zinnoxid oder Indium-Zinn-Oxid hergestellt werden.

14. Verfahren nach einem der Ansprüche 8 bis 13, wobei die zweiten Elektrodenschichten (13) aus Silber hergestellt werden.

15. Verfahren nach Anspruch 14, wobei die zweiten Elektrodenschichten (13) durch Abscheiden der Metallschicht aus Silber im Vakuum nach Abscheiden der ersten und/oder zweiten transparenten Metalloxidschicht aus Zinkoxid, Zinnoxid oder Indium-Zinn-Oxid gebildet werden.

16. Verfahren nach einem der Ansprüche 12 bis 15, wobei die Gesamtdicke der ersten und zweiten transparenten Metalloxidschicht auf 1000 Å eingestellt wird.

## Revendications

1. Pile solaire à couche mince intégrée (1) ayant une pluralité d'éléments unitaires (15) connectés en série, comprenant :
un substrat (3) ;
une pluralité de premières couches électrodes (5) d'oxyde conducteur transparent, divisées en une pluralité de régions et formées sur le substrat (3) ;
une pluralité de stratifiés, comprenant chacun une couche semi-conductrice (9) et une première couche électriquement conductrice (11) plaquée sur la couche semi-conductrice (9), disposés sur ladite pluralité de premières couches électrodes (5) de telle manière que chacun des stratifiés soit formé sur deux premières électrodes adjacentes (5) et ait une ouverture de connexion (7) sur l'une des deux premières électrodes (5), ladite première couche électriquement conductrice n'étant pas formée dans ladite ouverture de connexion ; et
des deuxièmes couches électrodes (13) de matériau métallique, disposées sur chacun des stratifiés, dans un état dans lequel les deuxièmes couches électrodes (13) sont connectées électriquement à l'une des deux premières couches électrodes (5) par l'intermédiaire de l'ouverture de connexion (7) pour former une région interposée entre la deuxième couche électrode (13) et l'autre première couche électrode constituant l'élément unitaire (15) ;
**caractérisée en ce que**
ladite première couche électriquement conductrice (11) est constituée d'un matériau d'oxyde métallique transparent.

2. Pile solaire à couche mince intégrée selon la revendication 1, dans laquelle ladite première couche électriquement conductrice (11) a une épaisseur dans une plage située entre 600 Å et 1 200 Å (10 Å = 1 nm).

3. Pile solaire à couche mince intégrée selon la revendication 1 ou 2, comprenant en outre une deuxième couche électriquement conductrice d'oxyde métallique transparent entre la première couche électriquement conductrice transparente (11) et ladite deuxième couche électrode (13).

4. Pile solaire à couche mince intégrée selon la revendication 1, 2 ou 3, dans laquelle la deuxième couche électrode (13) est constituée d'argent.

5. Pile solaire à couche mince intégrée selon l'une quelconque des revendications 1 à 4, dans laquelle le matériau d'oxyde métallique transparent des premières et deuxièmes couches électriquement conductrices transparentes (11) est constitué d'oxyde de zinc, d'oxyde d'étain ou d'oxyde d'indium et d'étain.

6. Pile solaire à couche mince intégrée selon l'une quelconque des revendications 1 à 5, dans laquelle les couches semi-conductrices (9) sont dopées à l'hydrogène.

7. Pile solaire à couche mince intégrée selon l'une quelconque des revendications 3 à 6, dans laquelle l'épaisseur totale desdites premières et deuxièmes couches d'oxyde métallique transparent est fixée à 1 000 Å.

8. Procédé de fabrication d'une pile solaire à couche mince intégrée (1) ayant une pluralité d'éléments unitaires (15) connectés en série, comprenant les étapes, dans l'ordre donné, consistant à :
former sur un substrat (3) une pluralité de premières couches électrodes (5) d'oxyde conducteur transparent, chacune desdites couches (5) étant la première couche de la pluralité d'éléments unitaires (15) ;
former un stratifié comprenant une couche semi-conductrice (9) et une première couche électriquement conductrice (11) plaquée sur la couche semi-conductrice (9) couvrant ladite pluralité de premières couches électrodes (5) ;
former des ouvertures de connexion (7), chacune d'elles pénétrant le stratifié et exposant une partie de chaque première couche électrode (5) ;
former une deuxième couche électrode (13) de matériau métallique sur le stratifié, dans un état dans lequel la deuxième couche électrode (13) est connectée électriquement à chaque première couche électrode (5) par l'intermédiaire de ladite ouverture de connexion (7) ; et
former des rainures d'isolation (19) pour diviser la deuxième couche électrode (13) en une pluralité de deuxièmes régions électrodes (13), dans un état dans lequel les deuxièmes régions électrodes (13) sont connectées électriquement à l'une de deux premières couches électrodes adjacentes (5) par l'intermédiaire de l'ouverture de connexion (7) pour former une région interposée entre la deuxième région électrode (13) et l'autre première couche électrode constituant l'élément unitaire (15) ;
**caractérisé en ce que**
ladite première couche électriquement conductrice (11) est réalisée en un matériau d'oxyde métallique transparent.

9. Procédé selon la revendication 8, dans lequel l'épaisseur des premières couches électriquement conductrices transparentes (11) est fixée dans la plage située entre 600 Å et 1 200 Å.

10. Procédé selon la revendication 8 ou 9, dans lequel les couches semi-conductrices (9) sont dopées à l'hydrogène.

11. Procédé selon les revendications 8, 9 ou 10, dans lequel les couches électriquement conductrices transparentes (11) sont formées sans être exposées à l'eau ou à l'air extérieur après la formation desdites couches semi-conductrices (9).

12. Procédé selon l'une quelconque des revendications 8 à 11, comprenant en outre l'étape consistant à :
former une deuxième couche électriquement conductrice d'oxyde métallique transparent entre la première couche électriquement conductrice transparente (11) et ladite deuxième couche électrode (13).

13. Procédé selon l'une quelconque des revendications 8 à 12, dans lequel le matériau oxyde métallique transparent des premières et deuxièmes couches électriquement conductrices transparentes est réalisé en oxyde de zinc, oxyde d'étain ou oxyde d'indium et d'étain.

14. Procédé selon l'une quelconque des revendications 8 à 13, dans lequel lesdites deuxièmes couches électrodes (13) sont réalisées en argent.

15. Procédé selon la revendication 14, dans lequel les deuxièmes couches électrodes (13) sont formées en déposant ladite couche métallique d'argent sous vide après dépôt desdites premières et/ou deuxièmes couches d'oxyde métallique transparent d'oxyde de zinc, d'oxyde d'étain ou d'oxyde d'indium et d'étain.

16. Procédé selon l'une quelconque des revendications 12 à 15, dans lequel l'épaisseur totale desdites premières et deuxièmes couches d'oxyde métallique transparent est fixée à 1 000 Å.
